# EUROPÄISCHE PATENTSCHRIFT

(11) **EP 0 736 904 B1**
(45) Veröffentlichungstag und Bekanntmachung des Hinweises auf die Patenterteilung: **04.12.2002**
(21) Anmeldenummer: 95105212.5
(22) Anmeldetag: 06.04.1995
(51) Int. Cl.: H01L 27/02

(54) **Integrierte Halbleiterschaltung mit einem Schutzmittel**
Semiconductor integrated circuit including protection means
Circuit intégré semi-conducteur comprenant des moyens de protection

(43) Veröffentlichungstag der Anmeldung: 09.10.1996
(73) Patentinhaber: Infineon Technologies AG, 81669 München (DE)
(72) Erfinder: Nikutta, Wolfgang, D-81541 München (DE); Reczek, Werner, Dr., D-85521 Ottobrunn (DE)
(74) Vertreter: Müller - Hoffmann & Partner

(56) Entgegenhaltungen:
- EP-A- 0 352 896
- EP-A- 0 623 958
- EP-A- 0 632 560
- PATENT ABSTRACTS OF JAPAN vol. 015 no. 390 (E-1118) ,3.Oktober 1991 & JP-A-03 156965 (FUJITSU LTD) 4.Juli 1991,
- PATENT ABSTRACTS OF JAPAN vol. 018 no. 095 (E-1509) ,16.Februar 1994 & JP-A-05 299598 (HITACHI LTD;OTHERS: 01) 12.November 1993,
- PATENT ABSTRACTS OF JAPAN vol. 018 no. 311 (E-1561) ,14.Juni 1994 & JP-A-06 069454 (HITACHI LTD) 11.März 1994,

## Beschreibung

Die Erfindung bezieht sich auf eine integrierte Halbleiterschaltung mit einem Halbleiter-Substrat, einer Anzahl von ersten Potentialschienen, die im Betrieb ein erstes Versorgungspotential der Halbleiterschaltung führen, einer Anzahl von zweiten Potentialschienen, die im Betrieb ein zweites Versorgungspotential der Halbleiterschaltung führen, einer Anzahl von auf dem Halbleiter-Substrat ausgebildeten Schaltungsteilen, die zur Versorgung mit elektrischer Spannung zwischen jeweils einer der ersten und einer der zweiten Potentialschienen angeschlossen sind, einer auf dem Halbleiter-Substrat ausgebildeten und jedem Schaltungsteil zugeordneten Anschlußstelle, an welcher im Betrieb des Schaltungsteiles ein Eingangs- oder Ausgangssignal für den jeweiligen Schaltungsteil anliegt, und einer dem Schaltungsteil zugeordneten und auf dem Halbleiter-Substrat ausgebildeten Schutzschaltung gegen Überspannungen, die eingangsseitig mit der zugehörenden Anschlußstelle des jeweiligen Schaltungsteiles und ausgangsseitig mit dem jeweiligen Schaltungsteil verbunden ist.

Eine derartige integrierte Halbleiterschaltung ist beispielsweise aus der EP 0 623 958 A1 bekannt. Integrierte Halbleiterschaltungen, insbesondere MOS-integrierte Halbleiterschaltungen sind bekanntlich gegenüber elektrostatischen Aufladungen (ESD - Elektrostatic Discharge) empfindlich, soweit diese auf deren Anschlüsse (PADs am Halbleiterchip; PINs am Halbleiterschaltungsgehäuse) einwirken. Die bekannte integrierte Halbleiterschaltung besitzt zur Vermeidung von ESD-Schäden auf dem Halbleitersubstrat ausgebildete Schutzschaltungen zur Ableitung von Überspannungen, welche jeweils zwischen einer Anschlußstelle (PAD) und einem der entsprechenden Anschlußstelle zugeordneten Schaltungsteil angeordnet sind, und welche entweder mit einem ersten Versorgungspotential VSS (meist Masse bzw. Ground genannt) oder - seltener - mit einem zweiten Versorgungspotential VCC verbunden sind. Aus Layoutgründen, d.h. aus Gründen eines lediglich eingeschränkt zur Verfügung stehenden Platzes sind derartige ESD-Schutzschaltungen nur an dem jeweiligen lokalen Versorgungspotential in unmittelbarer Nähe des zugehörenden Schaltungsteiles angeschlossen, in der Regel an dem lokalen ersten Versorgungspotential VSS.

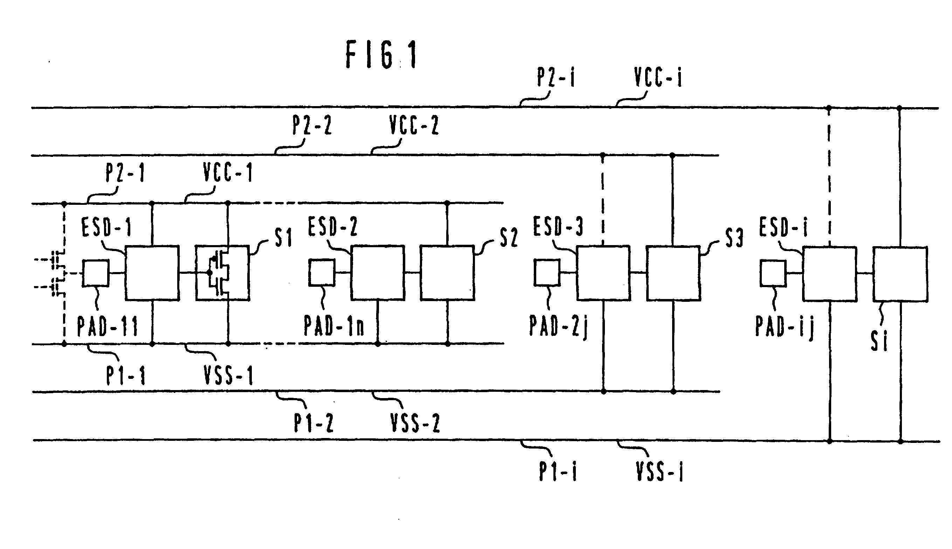

Fig. 1 zeigt in einer schematischen Ansicht die bekannte Anordnung einer integrierten Halbleiterschaltung mit ESD-Schutzschaltungen bei mehrfachen Versorgungsspannungsanschlüssen. Es ist eine Anzahl von ersten, im Baustein gegeneinander isolierte Potentialschienen P1-1, P1-2, ..., P1-i die im Betrieb ein erstes Versorgungspotential VSS-1, VSS-2, ... , VSS-i führen, und eine Anzahl von zweiten, gleichfalls im Baustein gegeneinander isolierte Potentialschienen P2-1, P2-2, ... P2-i vorgesehen, die im Betrieb ein zweites Versorgungspotential VCC-1, VCC-2, ... , VCC-i der Halbleiterschaltung führen. Der Grund dafür, daß die Potentialschienen für die Spannungsversorgung intern getrennt sind, liegt darin, daß Rausch-Quellen wie etwa Störungen der Eingangs-Buffer durch Stromspitzen aus den I/O-Treibern entkoppelt sind. Ferner ist eine Anzahl von auf dem Halbleitersubstrat ausgebildeten Schaltungsteilen S1, S2, S3, ..., Si vorgesehen, die zur Versorgung mit elektrischer Spannung zwischen jeweils einer der ersten und einer der zweiten Potentialschiene angeschlossen sind. Zum Schutz der Schaltungsteile Si gegen Überspannungen aufgrund einer ESD-Belastung sind Schutzschaltungen ESD-1, ESD-2, ESD-3, ..., ESD-i vorgesehen, die jeweils im Leitungspfad zwischen einer Anschlußstelle PAD-11, PAD-1n, ..., PAD-2j, PAD-ij und dem zugehörenden Schaltungsteil angeordnet, und mit der zugehörenden lokalen ersten Potentialschiene P1-1, P1-2, ..., P1-i gekoppelt sind.

Im folgendem soll die Verwendung der Indizes in der vorliegenden Anmeldung erläutert werden. Der Index i bezeichnet die Anzahl der Spannungsversorgungen der integrierten Halbleiterschaltung. Beispielsweise besitzt ein 256 K x 16 DRAM 3 getrennte Spannungsversorgungen (i = 3), d.h. 3 VCC- und 3 VSS-Pins, die in der Regel im Baustein gegeneinander isoliert sind. Die Bezeichnung PAD-kj bedeutet eine Anschlußstelle bzw. ein PAD mit der laufenden Nummer j an der Spannungsversorgung k (1 ≤ k ≤ i). Somit bezeichnet beispielsweise PAD-37 eine Anschlußstelle (PAD) mit der laufenden 7, welche mit ihrer Schutzstruktur an der Spannungsversorgung VSS-3 und/oder VCC-3 angeschlossen ist.

Bei der vorbekannten integrierten Halbleiterschaltung mit mehreren Spannungsversorgungen gibt es insbesondere zwei Typen von kritischen ESD-Belastungsfällen, die nach MIL-Standard charakterisiert werden können.

Der eine Typ bezieht sich auf einen ESD-Belastungsfall von PAD gegen Spannungsversorgung. Im Fall von i ≠ k liegt eine ESD-Belastung der Anschlußstelle PAD-kj gegen die Spannungsversorgung VCC-i oder VSS-i vor. Dies bedeutet, daß die lokale ESD-Schutzstruktur an PAD-kj nicht an VCC-i bzw. VSS-i angeschlossen ist und somit elektrisch nicht wirksam sein kann. Die ESD-Entladung wird in diesem Fall daher über andere aktive Strukturen erfolgen (Gate-Oxide, PN-Dioden), die hierbei zerstört werden können. Die im Falle von i=k vorliegende ESD-Belastung der Anschlußstelle PAD-ij gegen die lokale Spannungsversorgung VCC-i oder VSS-i ist unkritisch, da die ESD-Schutzstruktur im Entladepfad aktiv ist.

Der zweite Typ eines kritischen ESD-Belastungsfalles bezieht sich auf eine ESD-Belastung PAD gegen PAD. Im Falle von i=k liegt eine Belastung von PAD-kj gegen PAD-km (Anschlußstellen an gemeinsamer VCC-k- bzw. VSS-k-Schiene) vor. Hierbei erfolgt bei der bekannten integrierten Halbleiterschaltung eine ESD-Entladung über die Strecke PAD-kj - ESD - VCC-k bzw. VSS-k - ESD - PAD-km, d.h. die beiden ESD-Schutzstrukturen sind dabei in Serie geschaltet. Im Falle von i ≠ k liegt eine ESD-Belastung von PAD-ij gegen PAD-km (Anschlußstellen bzw. PADs an unterschiedlichen VCC- bzw. VSS-Schienen) vor. Dies bedeutet für die bekannte integrierte Halbleiterschaltung, daß die lokale ESD-Schutzstruktur an PAD-ij und PAD-km nicht im Entladepfad liegen und deshalb elektrisch nicht wirksam sind. Die ESD-Entladung wird daher wieder über andere aktive Strukturen erfolgen (Gate-Oxide, PN-Dioden), die damit zerstört werden können.

Bei den bekannten ESD-Schutzschaltungen bei mehrfachen Versorgungsspannungsanschlüssen der integrierten Halbleiterschaltung besteht somit der Nachteil, daß insbesondere bei ESD-Belastungen "über Kreuz" zwischen einer Anschlußstelle (PAD) und einer nicht lokalen Spannungsversorgung, beispielsweise zwischen PAD1-n und VSS-2 die lokale ESD-Schutzschaltung nicht im Entladungspfad angeordnet ist. Hierbei fließt in der Regel der ESD-Entladestrom über parasitäre Substratdioden (Diffusionsgebiete am PAD mit parasitären PN-Dioden zum Substrat) die dabei thermisch zerstört werden können. Hierbei ist zu berücksichtigen, daß, falls Versorgungspotentiale in der integrierten Halbleiterschaltung nicht niederohmig verbunden sind, im Rahmen der Produkt-Freigabe ESD-Belastungen nach MIL-Standard gegen alle Versorgungspins (VSSi, VCCi) vorgeschrieben sind.

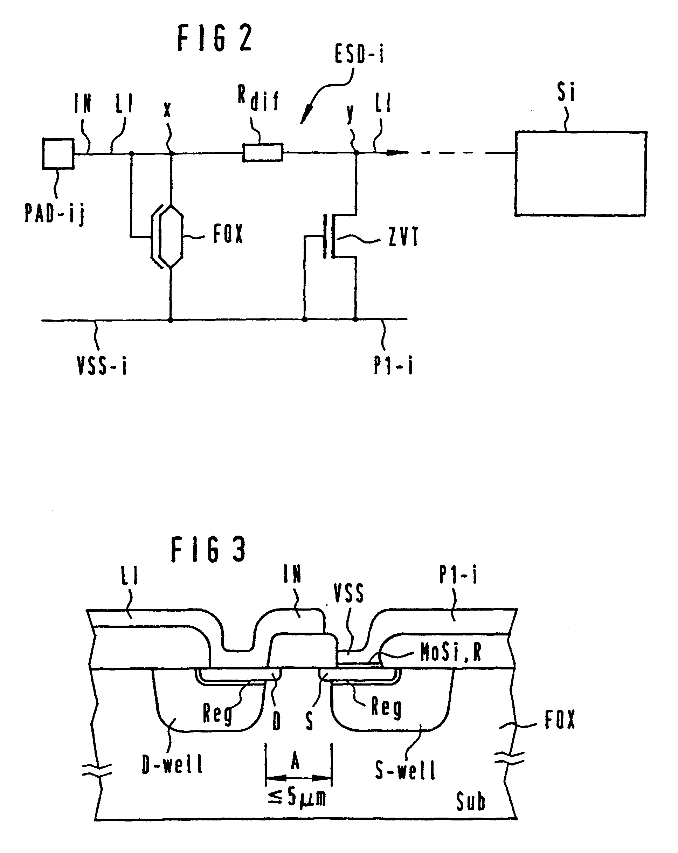

Eine beispielhafte Ausführung einer ESD-Schutzschaltung ist, wie in Fig. 2 dargestellt, folgendermaßen aufgebaut: Zwischen einer beispielsweise ein Eingangssignal IN führenden Leitung LI und der ersten Potentialschiene P1-i ist ein Feldoxid-Transistor FOX angeordnet, dessen Gate mit der Leitung LI verbunden ist. Der Anschlußpunkt des Feldoxid-Transistors FOX an die Leitung LI sei mit x bezeichnet. Im weiteren Verlauf der Leitung LI ist, anschließend an den Punkt x ein Diffusionswiderstand Rdif angeordnet, an dessen Ende oder kurz danach sich der eine Anschluß einer feldgesteuerten Diode ZVT befindet. Der andere Anschluß der feldgesteuerten Diode ZVT ist ebenfalls mit der ersten Potentialschiene P1-i verbunden.

Der eine Anschluß der feldgesteuerten Diode ZVT bildet dabei einen weiteren Punkt y der Leitung LI. Hierbei ist angenommen, daß die feldgesteuerte Diode ZVT als sogenannter 0-Volt-Transistor ausgeführt ist. Bei dem als feldgesteuerte Diode ZVT fungierenden 0-Volt-Transistor gemäß Fig. 2 ist das die Feldsteuerung bewirkende Gate (ebenfalls wie seine Source) mit der ersten Potentialschiene P1-i verbunden. Die Source- und Drain-Bereiche des Feldoxid-Transistors FOX sind, wie üblich, als Diffusionsgebiete ausgelegt (Source-Bereich S, Drain-Bereich D). Unterhalb des Source-Bereiches S und unterhalb des Drain-Bereiches D ist jeweils ein wannenförmiger Bereich S-well bzw. D-well ausgebildet. Diese wannenförmigen Bereiche S-well, D-well sind im Abstand zueinander angeordnet, wie in Fig. 3 dargestellt. Sie sind vom selben Leitungstyp wie der jeweilige Source- bzw. Drain-Bereich S, D.

Bezüglich weiterer Einzelheiten, Merkmale und Vorteile der bekannten ESD-Schutzschaltung ESD-i wird ausdrücklich auf die Vorveröffentlichte Europäische Patentanmeldung EP 0 623 958 A1 derselben Anmelderin verwiesen und vollinhaltlich Bezug genommen.

Ausgehend von diesem Stand der Technik liegt der Erfindung die Aufgabe zugrunde, die bekannte integrierte Halbleiterschaltung derart weiterzubilden, daß diese auch höheren Anforderungen an einen ESD-Schutz entsprechen und insbesondere ESD-Belastungen über Kreuz wirksam vermieden werden können, ohne den Platzbedarf von ESD-Schutzschaltungen zu vergrößern.

Diese Aufgabe wird mit den kennzeichnenden Mitteln des Patentanspruches 1 gelöst. Erfindungsgemäß ist vorgesehen, daß die Schutzschaltung einen zur Ableitung von Überspannung dienenden Entladungspfad besitzt, der mit einer im Betrieb gegenüber sämtlicher Anschlußstellen der Schaltungsteile ein gemeinsames Bezugspotential führenden Sammel-Potentialschiene gekoppelt ist. Dem Prinzip der Erfindung folgend ist die ESD-Schutzschaltung somit zwischen der zugehörenden Anschlußstelle (PAD) des Schaltungsteiles und eine für alle PADs gemeinsame Potentialschiene angeschlossen. Auf diese Weise sind alle denkbaren ESD-Belastungsfälle gegen ein beliebiges Versorgungspotential symmetrisch angeordnet. Hierbei fließt der ESD-Entladestrom in allen Fällen über den Leitungspfad Schutzstruktur-Diode der gemeinsamen Sammel-Potentialschiene. Eine ESD-Belastung der Substratdioden kann auf diese Weise wirksam verhindert werden, ohne eine platzintensive und komplizierte Schutzschaltung bzw. Schutzstruktur vorsehen zu müssen.

Die Sammelpotentialschiene kann eine vollkommen eigenständige auf dem Halbleitersubstrat ausgebildete Leitung sein; in einer anderen Anordnung stellt die Sammelpotentialschiene eine auf dem Halbleitersubstrat ohnehin gebildete gemeinsame Potentialschiene dar, die im Betrieb der Halbleiterschaltung ein für sämtliche Schaltungsteile gemeinsames Potential führt. Die Auswahl der hierfür geeigneten gemeinsamen Potentialschiene hängt dabei von den vorhandenen Schutzstrukturen und den elektrischen Spezifikationen der angeschlossenen PINs ab. Hierbei hängt die gewählte Schutzstruktur (ESD) von der zur Verfügung stehenden Technologie und der Chip-Spezifikation ab. Bei CMOS-Prozessen bieten sich Feldoxid-Transistoren, Bipolar-Transistoren oder auch Bipolardioden an. Die Effektivität der Schutzstruktur steigt mit kleinerer Durchbruchspannung und hoher Strombelastbarkeit. Als Bipolardioden können unter Umständen parasitäre PN-Dioden ausreichen, die in der Regel an den Versorgungsanschlüssen mit großem Flächenanteil vorhanden sind. Zusätzliche PN-Dioden, die als Halbleitervorrichtung bereits im Entwurf eingeplant werden, haben in der Regel eine höhere Belastbarkeit.

Insbesondere bei der Verwendung in einer dynamischen Halbleiterspeichervorrichtung vom CMOS-Typ wird in besonders bevorzugter Weise als Sammelpotentialschiene der Potentialring für die Substratspannung bzw. Bulkspannung (VBB) der Halbleiterschaltung gewählt. Dies hat zusätzlich den Vorteil, daß die Schutzstruktur der parasitären Substratdiode parallel geschaltet ist und unmittelbar Substratdurchbrüche verhindert. Die Schutzstruktur ist hierbei ein NPN-Bipolartransistor; die PN-Diode ist als Bauelement im Chip-Konzept eingebaut.

Die Erfindung wird nachstehend anhand von Ausführungsbeispielen vermittels der Zeichnung näher erläutert. Dabei zeigt:
- Figur 1: eine schematische Darstellung der Anordnung von ESD-Schutzschaltungen bei einer bekannten integrierten Halbleiterschaltung;
- Figur 2: eine schematische Darstellung einer ESD-Schutzschaltung;
- Figur 3: eine schematische Schnittansicht eines Teils der integrierten Halbleiterschaltung mit einem Schaltungsteil und der dem Schaltungsteil zugeordneten ESD-Schutzschaltung;
- Figur 4: eine schematische Darstellung der Anordnung einer erfindungsgemäßen integrierten Halbleiterschaltung bei mehrfachen Versorgungsspannungsanschlüssen; und
- Figur 5: eine schematische Draufsicht der Anordnung einer integrierten Halbleiterschaltung gemäß der Erfindung.

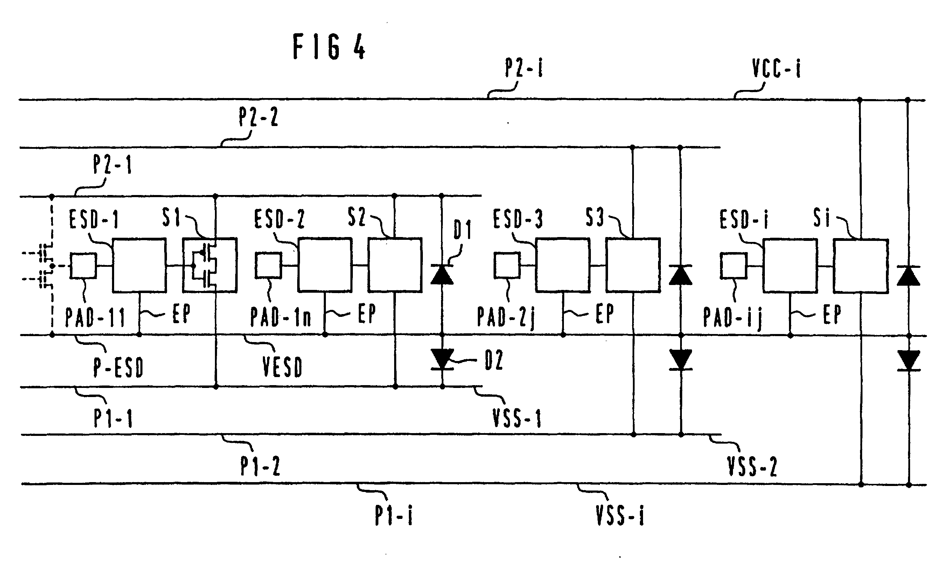

Die Fig. 2 bis 5 zeigen ein bevorzugtes Ausführungsbeispiel der Erfindung. Bei einer integrierten Halbleiterschaltung mit einem Halbleiter-Substrat Sub ist eine Anzahl von ersten Potentialschienen P1-1, P1-2, ..., P1-i, die im Betrieb ein erstes Versorgungspotential VSS-1, VSS-2, ... , VSS-i der Halbleiterschaltung führen, und eine Anzahl von zweiten Potentialschienen P2-1, P2-2, ..., P2-i, die im Betrieb ein zweites Versorgungspotential VCC-1, VCC-2, ... , VCC-i der Halbleiterschaltung führen, vorgesehen. Ferner ist eine Anzahl von auf dem Halbleitersubstrat ausgebildeten Schaltungsteilen S1, S2, S3, ..., Si vorgesehen, die zur Versorgung mit elektrischer Spannung zwischen jeweils einer der ersten und einer der zweiten Potentialschiene angeschlossen sind. Zum Schutz der Schaltungsteile Si gegen Überspannungen aufgrund einer ESD-Belastung sind Schutzschaltungen ESD-1, ESD-2, ESD-3, ..., ESD-i vorgesehen, die jeweils im Leitungspfad zwischen einer Anschlußstelle PAD-11, PAD-1n, ..., PAD-2j, PAD-ij und dem zugehörenden Schaltungsteil angeordnet sind. Jede Schutzschaltung ESD-i besitzt einen zur Ableitung von Überspannungen dienenden Entladungspfad EP, der mit einer im Betrieb gegenüber sämtlichen Anschlußstellen PAD-ij der Schaltungsteile Si ein gemeinsames Bezugspotential VESD führenden Sammel-Potentialschiene P-ESD gekoppelt ist, wobei im dargestellten Fall die Sammel-Potentialschiene P-ESD eine auf dem Halbleiter-Substrat (Sub) ohnehin gebildete gemeinsame Potentialschiene darstellt, die im Betrieb der Halbleiterschaltung ein für sämtliche Schaltungsteile gemeinsames Potential VBB führt, und zwar der Potential-Ring für die Substratspannung VBB der Halbleiterschaltung.
Im Falle eines Halbleitersubstrates vom P-Typ ist die Substrat- bzw. Bulkspannung die im Chip negativste Spannung dar. Beispielsweise beträgt der Wert der internen Substratspannung minus 2,5 V.

Erfindungsgemäß können nunmehr auch die beiden eingangs genannten Typen von kritischen ESD-Belastungsfällen vermieden werden.

Bei dem einen Typ des ESD-Belastungsfalles von PAD gegen Spannungsversorgung erfolgt im Falle von i ≠ k die Entladung stets über die definierte Strecke PAD-kj-ESD-VESD-Diode-VCC-i bzw. VSS-i. Der ESD-Entladestrom fließt über den Pfad Schutzstruktur-VESD-Diode, so daß die Substratdioden selbst nicht belastet werden. Im Falle von i = k erfolgt die Entladung ebenfalls über die definierte Strecke PAD-kj-ESD-VESD-Diode-VCC-i bzw. VSS-i, also analog dem Fall i ≠ k gemäß der Erfindung. Bei dem zweiten Typ des kritischen ESD-Belastungsfalles, d.h. einer ESD-Belastung PAD gegen PAD erfolgt die Entladung in vergleichbarer Weise über die definierte Strecke PAD-kj-ESD-VESD-ESD-PAD-km. Im Falle von i ≠ k, der bei der vorbekannten ESD-Schutzstruktur gegen Überspannungen nicht geschützt ist, erfolgt erfindungsgemäß die Entladung ebenfalls über die definierte Strecke PAD-ij-ESD-VESD-ESD-PAD-km.

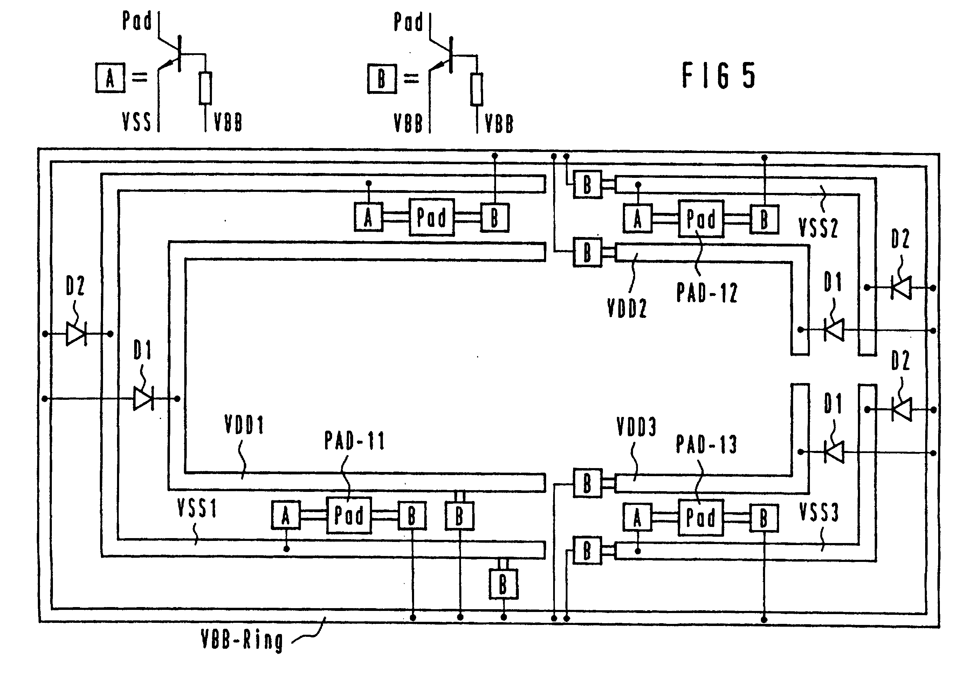

In der Fig. 5 bezeichnet das mit "A" gekennzeichnete Bauteil jeweils eine sogenannte Punch-Through-Einrichtung gemäß Einzeldarstellung, die an der jeweiligen Anschlußstelle (PAD) angeschlossen ist und mit der lokalen Potentialschiene VSS-i verbunden ist, und das mit "B" gekennzeichnete Bauteil bezeichnet einen NPN-Bipolartransistor gemäß Einzeldarstellung, der an der jeweiligen Anschlußstelle (PAD) angeschlossen ist und mit der gemeinsamen Potentialschiene VBB verbunden ist. Darüber hinaus könen optional wenigstens einige der Bauteile "B" wie aus Fig. 5 ersichtlich auch zwischen VSS-i bzw. VDD-i und VBB angeschlossen sein, so daß sich in diesem Fall eine volle Symmetrie hinsichtlich ESD-Belastungen auch hinsichtlich VCC-i - VCC-k, VSS-i - VSS-k, und/oder VCC -i - VSS-k ergibt.

Die Dioden D1, D2 stellen NP-Bipolardioden dar und sind gemäß der Darstellung nach Fig. 5 an die jeweiligen lokalen Potentialschienen VSS-i bzw. VDD-i und mit der gemeinsamen Potentialschiene VBB verbunden.

Somit sind bei der erfindungsgemäßen integrierten Halbleiterschaltung sämtliche ESD-Belastungsfälle gegen ein beliebiges Versorgungspotential symmetrisch, so daß insbesondere auch ESD-Belastungen über Kreuz wirksam vermieden werden können.

## Patentansprüche

1. Integrierte Halbleiterschaltung mit einem Halbleiter-Substrat (Sub),
- mit einer Mehrzahl von ersten Potentialschienen (P1-i), die im Betrieb ein erstes Versorgungspotential (VSS-i) der Halbleiterschaltung führen,
- mit einer Mehrzahl von zweiten Potentialschienen (P2-i), die im Betrieb ein zweites Versorgungspotential (VCC-i) der Halbleiterschaltung führen,
- mit einer Mehrzahl von auf dem Halbleiter-Substrat (Sub) ausgebildeten Schaltungsteilen (Si), die zur Versorgung mit elektrischer Spannung zwischen jeweils einer der ersten und einer der zweiten Potentialschienen angeschlossen sind,
- mit einer Mehrzahl von auf dem Halbleiter-Substrat (Sub) ausgebildeten und jeweils einem Schaltungsteil (Si) zugeordneten Anschlußstellen (PAD-ij), an welchen im Betrieb des Schaltungsteiles (Si) jeweils ein Eingangs- oder Ausgangssignal für den jeweiligen Schaltungsteil (Si) anliegt und
- mit einer Mehrzahl von jeweils einer Anschlußstelle (PAD-ij) zugeordneten und auf dem Halbleiter-Substrat (Sub) ausgebildeten Schutzschaltungen (ESD-i) gegen Überspannungen, die jeweils mit der zugehörenden Anschlußstelle (PAD-ij) und mit jeweils einem Schaltungsteil verbunden sind,
wobei die Schutzschaltungen (ESD-i) jeweils
- einen Entladungspfad (EP) zur Ableitung von Überspannungen,
- einen Feldoxid-Transistor (FOX),
- eine feldgesteuerte Diode (ZVT) und
- einen Diffusionswiderstand (Rdif) aufweisen,
wobei die Source des Feldoxid-Transistors (FOX) mit dem Entladungspfad (EP) und dessen Gate und dessen Drain mit einer mit der zugehörenden Anschlußstelle (PAD-ij) gekoppelten Leitung (LI),
ein erster Anschluss des Diffusionswiderstands (Rdif) mit der Drain des Feldoxid-Transistors (FOX) und ein zweiter Anschluss des Diffusionswiderstands (Rdif) mit einem ersten Anschluss der feldgesteuerten Diode (ZVT),
ein zweiter Anschluss der feldgesteuerten Diode (ZVT) mit dem Entladungspfad (EP),
- für Anschlussstellen (PAD-ij) für Eingangssignale das Schaltungsteil (Si) mit dem ersten Anschluss der feldgesteuerten Diode (ZVT) verbunden ist,
**dadurch gekennzeichnet, dass**
- die Entladungspfade (EP) der Schutzschaltungen (ESD-i) mit einer ein Bezugspotential (VESD) führenden Sammel-Potentialschiene (P-ESD) verbunden sind und
- die Sammel-Potentialschiene (P-ESD) über jeweils wenigstens eine Diode (D1,D2) mit den ersten (P1-i) und den zweiten (P2-i) Potentialschienen verbunden ist, wobei die Dioden (D1,D2) jeweils mit den Anoden zur Sammel-Potentialschiene orientiert sind.

2. Integrierte Halbleiterschaltung nach Anspruch 1,
**dadurch gekennzeichnet, dass**
die Sammel-Potentialschiene (P-ESD) der Potential-Ring für eine Substratspannung (VBB) der Halbleiterschaltung ist.

3. Integrierte Halbleiterschaltung nach einem der Ansprüche 1 bis 2,
**dadurch gekennzeichnet, dass**
die feldgesteuerte Diode (ZVT) als 0-Volt-Transistor ausgeführt ist.

## Claims

1. Semiconductor integrated circuit having a semiconductor substrate (Sub),
- having a multiplicity of first busbars (P1-i), which, during operation, conduct a first supply potential, (VSS-i) of the semiconductor circuit,
- having a multiplicity of second busbars (P2-i), which, during operation, conduct a second supply potential (VCC-i) of the semiconductor circuit,
- having a multiplicity of circuit components (Si) which are formed on the semiconductor substrate (Sub) and which, in order to be supplied with electrical voltage, are connected between one of the first and one of the second busbars in each case,
- having a multiplicity of connecting points (PAD-ij) which are formed on the semiconductor substrate (Sub), and are assigned to a circuit component (Si) and to which, during the operation of the circuit component (Si), an input signal or output signal for the respective circuit component (Si) is applied in each case, and
- having a multiplicity of circuits (ESD-i) for protection against overvoltages, which circuits (ESD-i) are each assigned to a connecting point (PAD-ij), are formed on the semiconductor substrate (Sub) and are each connected to the associated connecting point (PAD-ij) and to one circuit component each, the protection circuits (ESD-i) each having
- a discharge path (EP) for diverting overvoltages,
- a field oxide transistor (FOX),
- a field controlled diode (ZVT), and
- a diffusion resistor (Rdif),
the source of the field oxide transistor (FOX) being connected to the discharge path (EP), and its gate and its drain being connected to a line (LI) which is connected to the associated connection point (PAD-ij), a first terminal of the diffusion resistant Rdif) being connected to the drain of the field oxide transistor (FOX), and a second terminal of the diffusion resistor (Rdif) being connected to a first terminal of the field-controlled diode (ZVT),
a second terminal of the field-controlled diode (ZVT) being connected to the discharge path (EP),
- and the circuit component (Si) being connected to the first terminal of the field-controlled diode (ZVT) for connecting points (PAD-ij) for input signals, **characterized in that**
- the discharge path (EP) of the protection circuit (ESD-i) being connected to a collecting busbar (P-ESD) which conducts a reference potential (VESD), and
- the collecting busbar (P-ESD) being connected, via at least one diode(D1, D2) in each case, to the first (P1-i) and the second (P2-i) busbar, the diodes (D1, D2) being each aligned with the anodes with respect to the collecting busbar.

2. Semiconductor integrated circuit according to Claim 1, **characterized in that** the collecting busbar (P-ESD) is the potential ring for a substrate voltage (VBB) of the semiconductor circuit.

3. Semiconductor integrated circuit according to one of Claims 1 to 2, **characterized in that** the field-controlled diode (ZVT) is embodied as a 0-volt transistor.

## Revendications

1. Circuit intégré à semiconducteur ayant un substrat (Sub) semiconducteur,
- comprenant une pluralité de premières barres (P1-i) de potentiel qui, en fonctionnement, appliquent un premier potentiel (VSS-i) d'alimentation au circuit à semiconducteur,
- comprenant une pluralité de deuxièmes barres (P2-i) de potentiel qui, en fonctionnement, appliquent un deuxième potentiel (VCC-i) d'alimentation au circuit à semiconducteur,
- comprenant une pluralité de parties (Si) de circuit qui sont constituées sur le substrat (Sub) semiconducteur et qui sont raccordées pour l'alimentation en une tension électrique, entre respectivement l'une des premières et l'une des deuxièmes barres de potentiel,
- comprenant une pluralité de points (PAD-ij) de raccordement qui sont constitués sur le substrat (Sub) à semiconducteur, qui sont associés respectivement à une partie (Si) de circuit et sur lesquels s'applique en fonctionnement de la partie (Si) de circuit, respectivement, un signal d'entrée ou de sortie pour la partie (Si) respective de circuit, et
- comprenant une pluralité de circuits (ESD-i) de protection vis-à-vis de surtensions, qui sont associés respectivement à un point (PAD-ij) de raccordement, qui sont constitués sur le substrat (Sub) à semiconducteur et qui sont reliés respectivement aux points (PAD-ij) de raccordement associés et à respectivement une partie de circuit,
les circuits (ESD-i) de protection ayant respectivement :
- un trajet (EP) de décharge de dérivation de surtension,
- un transistor (FOX) à oxyde de champ,
- une diode (ZVT) à commande par un champ, et
- une résistance (Rdif) de diffusion,
la source du transistor (FOX) à oxyde de champ étant reliée au trajet (EP) de décharge et sa grille et son drain à un conducteur (LI) couplé au point (PAD-ij) associé de raccordement,
une première borne de la résistance (Rdif) de diffusion étant reliée au drain du transistor (FOX) à oxyde de champ et une deuxième borne de la résistance (Rdif) de diffusion étant reliée à une première borne de la diode (ZVT) à commande par un champ,
une deuxième borne de la diode (ZVT) à commande par un champ étant reliée au trajet (EP) de décharge,
- pour des points (PAD-ij) de raccordement pour des signaux d'entrée, la partie (Si) de circuit étant reliée à la première borne de la diode (ZVT) à commande par un champ
**caractérisé en ce que**
- les trajets (EP) de décharge des circuits (ESD-i) de protection sont reliés à une barre (P-ESD) collectrice de potentiel appliquant un potentiel (VESD) de référence, et
- la barre (P-ESD) collectrice de potentiel est reliée par respectivement au moins une diode (D1, D2) aux premières (P1-i) et aux deuxièmes (P2-i) barres de potentiel, les diodes (D1, D2) étant orientées respectivement en ayant les anodes vers la barre collectrice de potentiel.

2. Circuit intégré à semiconducteur suivant la revendication 1, **caractérisé en ce que** la barre (P-ESD) collectrice de potentiel est l'anneau de potentiel pour une tension (VBB) de substrat du circuit à semiconducteur.

3. Circuit intégré à semiconducteur suivant l'une des revendications 1 à 2, **caractérisé en ce que** la diode (ZVT) à commande par un champ est réalisée en transistor à 0 V.
